Europäisches Patentamt

European Patent Office

Office européen des brevets

(19)

(11) Publication number: **0 134 967**
**B1**

(12) # EUROPEAN PATENT SPECIFICATION

(45) Date of publication of patent specification: **13.01.88**

(51) Int. Cl.⁴: **G 06 F 1/00**

(21) Application number: **84107802.5**

(22) Date of filing: **05.07.84**

(54) **A data processing system incorporating an automatic reset arrangement.**

(30) Priority: **12.08.83 US 522894**

(43) Date of publication of application:
**27.03.85 Bulletin 85/13**

(45) Publication of the grant of the patent:
**13.01.88 Bulletin 88/02**

(84) Designated Contracting States:
**AT BE CH DE FR GB IT LI NL SE**

(56) References cited:
**US-A-4 017 696**

**PATENTS ABSTRACTS OF JAPAN, vol. 7, no. 192 (P-218)1337r, 23rd August 1983**

**PATENTS ABSTRACTS OF JAPAN, vol. 6, no. 5(P-97)883r, 13th January 1982**

(73) Proprietor: **International Business Machines Corporation**
**Old Orchard Road**
**Armonk, N.Y. 10504 (US)**

(72) Inventor: **Freeman, Joseph Wayne**
**705 Edenburg Drive**
**Columbia Tennessee 38401 (US)**
Inventor: **Webb, Gary Edward**
**5254 Palm Way**
**Lake Worth Florida 33463 (US)**

(74) Representative: **Grant, Iain Murray**
**IBM United Kingdom Limited Intellectual Property Department Hursley Park**
**Winchester Hampshire SO21 2JN (GB)**

Courier Press, Leamington Spa, England.

## Description

The present invention relates to data processing systems incorporating automatic reset arrangements and is directed to the problem of accommodating reset in such systems which accept and utilise program cartrides.

Program cartridges were first introduced into the computer field in the area of games computers. Essentially, these devices are read-only stores which provide additional programming features to those held in an internal read-only memory in the micro-computer itself. In a games computer system, for example, the cartridges hold control programs defining the characteristics of the different games which may be played on the system. US—A—4149027 (Asher and Hardy) shows such a games cartridge. While the greatest proportion of cartridges marketed at this time relate to games applications, they are beginning to be used for other applications. As they provide an extension of the internal control program in a microcomputer, they can be powerful tools in extending the capability of such systems in business and other professional applications. However, the fact that they contain control program data leads to one particular disadvantage. When a cartridge is installed or removed from a computer while the system is running, noise may be introduced into the address and data lines of the system as contacts between the cartridge and the receiving socket are made or broken respectively. This can lead to unpredictable loss of control of the system. In many cases, the only way to regain control is to switch the system off temporarily. Thereafter, as it powers up, control is again restored. This process is perfectly adequate for games computers and simple systems, as the power up time is relatively short. However, for more complex systems, particularly those using peripheral devices, such as diskette and hard disk files, the power up time is substantially longer and presents considerable inconvenience to the user.

It is, therefore, an object of the present invention to provide a resetting arrangement which is inexpensive and effective to prevent the requirement to switch off the computer system temporarily.

The present invention provides a data processing system including a processor and at least one releasably attached program cartridge, the processor including a reset circuit and physical and electrical means for the releasable attachment thereto of one or more program cartridges, the or each cartridge including mating attachment means, said attachment means being in the form of contacts on the processor and edge connectors on the potentially attaching cartridges, characterised in that one edge connector on the or each cartridge is shaped to short circuit a pair of contacts on the processor at an intermediate engagement position only, of the attachment means, to complete a processor reset circuit temporarily during insertion and removal of the respective cartridge with respect to the processor and to allow processor operations before and after insertion or removal of a cartridge.

JP—A—5 892 020 discloses the inhibiting of the operation of a processor on power-up, if a socket is empty due to a circuit in the processor not being earthed through the empty socket.

Were the socket to have had its contents changed in the mean time or while the processor was powered-up, no action would have been taken.

US—A—4 017 696 discloses an edge connector on a cartridge which is shaped to short circuit a pair of contacts at an intermediate engagement position only, of the attachment means, to complete an initialisation circuit during insertion of the respective cartridge with respect to the electronic system to avoid mistakes arising from the electronic system, which remains live gaining operational access to the cartridge until it is initialised, there being other contacts which take over and continue the completion after the cartridge is fully inserted.

The following description discloses, as an embodiment of the invention, a reset system in a microcomputer using program cartridges. Each cartridge is coupled to the computer through printed circuit board edge connectors which engage respective contacts in a socket mounted in the computer. One of the edge connectors includes a portion which extends into the area which would normally be occupied by an adjacent edge connector. The extending portion is shaped such that, as the cartridge is inserted into, or withdrawn from the socket, a temporary connection is made, through this edge connector, between corresponding adjacent contacts in the socket. A fixed potential on the contact which engages the main body of this edge connector, is, therefore, temporarily coupled to the adjacent contact to provide a reset signal from the adjacent contact to the microprocessor in the computer system. The fixed potential may be ground potential, in which case the reset signal comprises a reduction from a determined voltage level to zero during the temporary contact. As shown in the following description, the preferred configuration of the special edge connector is an L shape, with the horizontal arm running along the edge of the board.

The present invention will be described further with reference to an embodiment of the invention as illustrated in the accompaning drawings, in which:-

Figure 1 is a top view of a plug-in cartridge read-only memory device and its connector socket;

Figure 2 is a cross-sectional view of the connector and part of the cartridge read-only memory device taken along the line 2—2 of Figure 1; and

Figure 3 is a simplified circuit showing the connection between the cartridge and a microprocessor device.

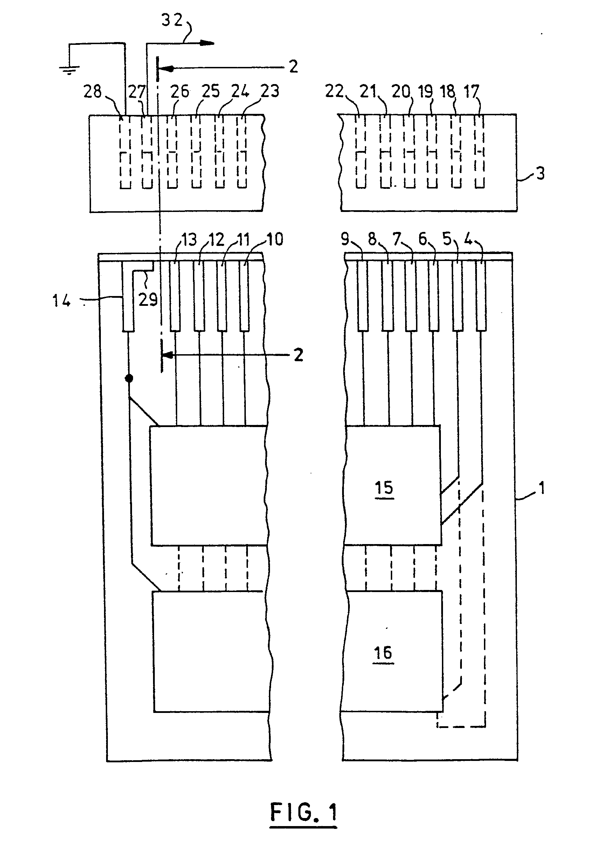

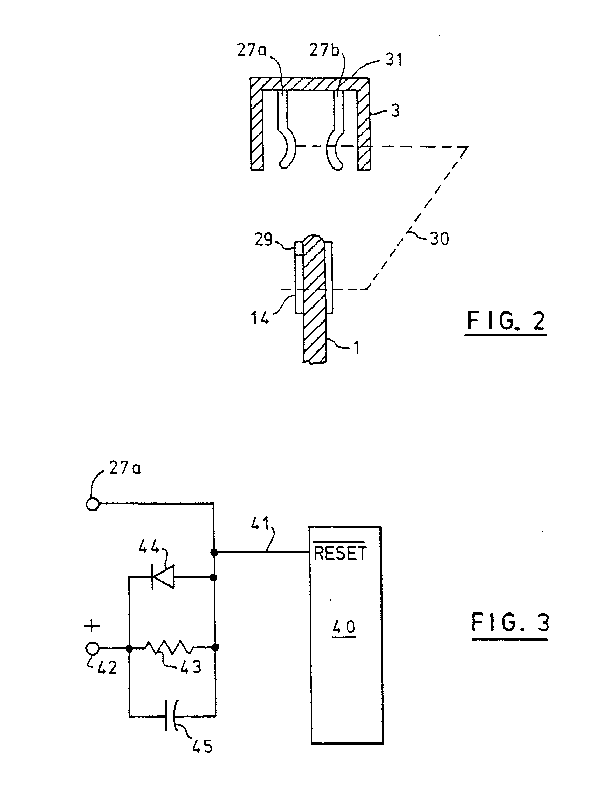

Figure 1 shows a cartridge read-only memory circuit board 1 and a connector socket device 3 for receiving board 1. In practise, board 1 would normally be contained within a protective cover, but this has not been shown for simplicity. Board 1 carries a plurality of edge connectors 4 through 14 which are connected to two ROM chips 15 and 16. Again, in order to simplify the drawing, the circuit board is only shown partially and only a few of the edge connectors are shown. In addition, as can be seen in Figure 2, the reverse side of the board also carries a further set of edge connectors. Taking, as an example, the ROM chips 15 and 16 to be 32K MOS IG FET devices, each requires fifteen address lines which are commonned between the chips, an enable line, a chip select line, a power and an earth line, again commonned, and eight output lines. The connector socket comprises a housing 3, which is fixedly mountable in the frame of a microcomputer central processing unit. Housing 3 carries a plurality of pairs of resilient connector contacts 17 through 28 which engage the respective pairs of edge connectors on board 1 when the board is slotted into the connector socket.

The present discussion is particularly concerned with the earth edge connector on board 1 and its connection to two of the contacts in the connector socket. As can be seen in Figure 1, the earth edge connector, that is, connector 14, has a portion 29 which projects from the connector into the area of board 1 which would normally be occupied by an edge connector adjacent connector 14. The arrangement is such that as board 1 is slotted into the connector socket, projection 29 is momentarily engaged by the associated contact of connector contact pair 27. Similarly, when board 1 is removed from the connector socket, projection 29 is again momentarily engaged by this connector contact. The operation of the arrangement can be seen in more detail in Figure 2. Here, the broken line 30 indicates the contact point of the edge connectors on board 1 and the contacts in the socket when the board is fully inserted into the socket. Thus, as the board is inserted, initially the edge connectors on board 1 make contact with their respective connector contacts and projection 29 contacts the left-hand contact 27a of pair 27a and 27b. Thereafter, as board 1 is further inserted towards its home position in which its upper end is adjacent the portion 31 of housing 3, projection 29 is cleared from contact 27a. Similarly, when board 1 is withdrawn, projection 29 contacts contact 27a for a period immediately preceding the complete withdrawal of board 1 from the socket.

Referring back to Figure 1, it is seen that the result of the temporary connections between projection 29 and the socket contact is to earth a line 32 via socket contact 27, projection 29, connector 14 and contact 28, which, as shown, is earthed. Edge connector 14, of course, also provides the cartridge earth connection from socket 3.

Figure 3 is a highly simplified diagram showing the connection between contact 27a (Figure 2) and a microprocessor 40. The microprocessor, in this case, is assumed to be on which is responsive to the lowering of a voltage on a NOT RESET input line 41 followed by a return to a high condition to switch to its reset state. With no external connection to contact 27a, and assuming a high input impedance at the microprocessor, the voltage on line 41 is substantially that of the supply voltage at terminal 42, as there is substantially not voltage drop across resistor 43. Whenever contact 27a is earthed by projection 29 (Figure 2), the potential of line 41 drops to earth, and when it subsequently leaves the projection, the input rises back up to the supply level. The reset pulse is lengthened by the RC characteristics of resistor 43 and capacitor 45. Thus, whenever the cartridge is entered into the socket or withdrawn therefrom, processor 40 is reset. Diode 44 provides a path to quickly discharge the capacitor when the system is powered down.

It is, of course, clear that contact 27a may be coupled to a RESET input of a microprocessor through an invert circuit. Alternatively, contact pad 14 may be the power supply pad for the cartridge so that, upon insertion or removal of the cartridge, a pulse at the supply voltage is produced on line 32 for a RESET input of the microprocessor.

The ROM cartridge, of course , provides program control data for a microcomputer system. Without some form of reset control when the cartridge is entered or withdrawn, noise signals generated thereby can cause significant problems. As this noise may be interpreted as program data, the computer may well attempt to execute the phantom instructions produced by the noise signals. These will at least produce error indications requiring action by the operator. The computer can, under some conditions produced by the phantom instructions, be forced into a 'hang' condition in which it waits for a further, non-existent instruction without the ability to return to its main control routine. In such a situation it may be impossible to reset the computer, and the only possible action is to switch it off completely and then switch on again. Depending on the complexity of the computer system, the power on sequence following the switch on can take various lengths of time, but in all cases it cause some delay. In the more sophisticated microcomputer systems. this power on sequence may include a check of the system, a keyboard check, an operating system load operation and peripheral device (e.g. diskette and hard disk) load operations. These operations may take a minute or more in some systems.

The reset system disclosed herein is simple, cheap to produce and effective. It will be noted that the reset signal is produced immediately after initial contact between the connector pads on the cartridge and the contacts on the cartridge holder. By the time the system has been reset, the contacts and pads are in wiping contact so that as soon as the cartridge is pushed to its home position further operations can continue. Similarly, when a cartridge is withdrawn, the reset signal occurs as the cartridge is finally exiting from the connector socket, so the system is again reset for the start of further operations.

Thus there has been provided a reset system for a microcomputer using program cartridges in which each cartridge includes a printed circuit board carrying along one edge a plurality of parallel edge connectors for connection of the cartridge to corresponding contacts of a socket in the microcomputer, in which one of the edge connectors includes a portion extending into the area on the board which would normally be occupied by an adjacent connector, the extending portion being configured to transiently engage a corresponding first contact of the socket upon insertion of the board into or withdrawal of the board from the socket, whereby a fixed potential applied by the microcomputer to a second socket contact corresponding to the main portion of said one edge connector is transiently transferred through the extending portion to the first contact to provide a reset signal thereon to reset the microprocessor of the microcomputer on insertion or withdrawal of the cartridge.

The extending portion is of similar width to said main portion and extends normal to the main portion into said area on the board, forming an L-shaped conductive area with said extending portion passing adjacent said one edge of the board into said area on the board. The extended connector can be the ground connector of the board, said second contact being connected to the ground of the microcomputer, and a predetermined potential on said second contact is reduced to ground potential of said transient engagement with the extending portion of the extended edge connector.

Each contact in the socket includes a portion curved towards the board to engage a portion of its associated edge connector remote from the edge of the board when the board is fully in position in the scket, the configuration of said extending portion being such that when the board is fully inserted into the socket, the curved portion of the first contact is out of engagement with the extending portion.

Expressed another way, there has been disclosed, in a microcomputer system adapted to use program cartridges, the combination of a cartridge socket having a first contact connected to a fixed potential and a second contact, adjacent the first contact, coupled to a reset input of a microprocessor in the system, and, in each cartridge, a printed circuit board having a plurality of edge connectors corresponding to the contacts in the socket, one of the edge connectors, corresponding to said first contact in the socket, having a projection extending into the area which would normally be occupied by an edge connector corresponding to said second contact and configured to transiently engage the second contact as the cartridge is inserted into or withdrawn from the socket.

While the invention, which resides in the combination of system and cartridge, and not in the cartridge, per se, has been described herein with reference to a particular embodiment thereof, it will be understood by those skilled in the art that various changes in form and detail may be made without departing from the scope of the appended claims.

**Claims**

1. A data processing system including a processor and at least one releasably attached program cartridge, the processor including a reset circuit (28, 27, 41, 42, 43, 44, 45) and physical and electrical means (3, 17—28) for the releasable attachment thereto of one or more program cartridges, the or each cartridge including mating attachment means (1, 4—14), said attachment means being in the form of contacts on the processor and edge connectors on the potentially attaching cartridges, characterised in that one edge connector (14) on the or each cartridge is shaped to short circuit a pair of contacts (27, 28) on the processor at an intermediate engagement position only, of the attachment means, to complete a processor reset circuit (27, 28, 41, 42, 43, 44, 45) temporarily during insertion and removal of the respective cartridge with respect to the processor and to allow processor operations before and after insertion or removal of a cartridge.

2. A data processing system as claimed in claim 1 wherein the edge connectors and contacts comprise respective preset arrays which are in one-to-one alignment when engaged, the shaped edge connector (14) having an extension (29) into an area that would normally be occupied by the adjacent edge connector.

3. A data processing system as claimed in claim 2 wherein said potential adjacent edge connector is omitted.

4. A data processing system as claimed in any preceding claim wherein one of the temporarily shorted pair of contacts remains in contact with the extended connector in full engagement of the attachment means, the other contact making and breaking contact with the extension during relative movement of the processor and cartridge.

5. A data processing system as claimed in claim 4 wherein at least in operation, the processor contact that remains in contact has a constant voltage maintained thereon, the contact that only makes transitory contact being normally maintained at a different voltage by the processor reset circuit save for when the two processor contacts are shorted, the change of the transient contact to the constant voltage of the other contact of the pair triggering a processor reset operation.

6. A data processing system as claimed in any preceding claim wherein the processor attachment means comprises a slotted socket (3) housing the contacts in the form of spring arms (27a, 27b) spaced along the length of the socket slot and biased towards the centre thereof in such a way that only a part of each arm towards the free end thereof can approach the centre of the slot, the cartridge attachment means comprising a mounting card (1) carrying the edge connectors in the form of conductive strips (4—14) extending in a parallel array inboard from the edge of the card to be inserted in the socket, the relative alignments of the arms and the strips being such as to make one-to-one contact of arm to strip inboard of the card when the card and socket are fully engaged, except in the case of the extended connector (14) and the pair of arms (27, 28) related to it, the strip extension (29) extending along the card edge to span the next adjacent strip position but only to a depth well short of the general contact making level (30) of the fully engaged card and socket, forming a substantially L-shaped conductive area.

## Patentansprüche

1. Datenverarbeitungsanordnung mit einem Prozessor und wenigstens einem lösbar befestigten Programmodul, wobei der Prozessor einen Rücksetzschaltkreis (28, 27, 41, 42, 43, 44, 45) und physikalische sowie elektrische Einrichtungen (3, 17—28) zum daran lösbaren Befestigen einer oder mehrerer Programmodule umfaßt, und wobei das oder jedes Modul paarweise aufeinander abgestimmte Anschlußeinrichtungen (1, 4—14) aufweist, die in Gestalt von Kontakten auf dem Prozessor und Seitensteckverbindungen an den anzuschließenden Modulen ausgebildet sind, dadurch gekennzeichnet, daß die Seitensteckverbindung (14) an dem oder jedem Modul so gestaltet ist, daß die ein Kontaktpaar (27, 28) auf dem Prozessor nur bei einer Zwischeneinsteckposition der Anschlußeinrichtung kurzschließt, um einen den Prozessor rücksetzenden Schaltkreis (27, 28, 41, 42, 43, 44, 45) zeitweilig während des Einsteckens und Herausziehens des jeweiligen Moduls bezüglich des Prozessors zu schließen und um Prozessoroperationen vor und nach dem Einstecken oder Herausziehen des Moduls zu gestatten.

2. Datenverarbeitungsanordnung nach Anspruch 1, bei der die Steckverbindungen und Kontakte jeweilige vorgegebene Gruppierungen umfassen, die sich bei einem Eingriff in einer eins-zu-eins Ausrichtung befinden, wobei die gestaltete Seitensteckverbindung (14) eine Verlängerung (29) in einen Bereich aufweist, der normalerweise durch die benachbarte Seitensteckverbindung benutzt sein würde.

3. Datenverarbeitungsanordnung nach Anspruch 2, bei der die potentielle benachbarte Seitensteckverbindung weggelassen ist.

4. Datenverarbeitungsanordnung nach einem der vorstehenden Ansprüche, bei der einer der beiden zeitweilig kurzgeschlossenen Kontakte mit dem verlängerten Anschlußkontakt der Anschlußeinrichtung in vollem Eingriff bleibt, wobei der andere Kontakt während der relativen Bewegung des Prozessors und des Moduls eine Verbindung herstellt und unterbricht.

5. Datenverarbeitungsanordnung nach Anspruch 4, bei der wenigstens im Betrieb der Prozessorkontakt, der in Verbindung bleibt, eine konstant gehaltene Spannung aufweist und bei der der Kontakt, der nur eine flüchtige Verbindung herstellt, normalerweise durch den Prozessorrücksetzschaltkreis auf einer unterschiedlichen Spannung gehalten wird, außer wenn die beiden Prozessorkontakte kurzgeschlossen sind, wobei die Veränderung des vorübergehenden Kontaktes zu der konstanten Spannung des anderen Kontaktes des Paares eine Rücksetzoperation des Prozessors auslöst.

6. Datenverarbeitungsanordnung nach einem der vorstehende Ansprüche, bei der die Prozessoranschlußeinrichtung eine geschlitzte Fassung (3) aufweist, die die Kontakte in Form von Federarmen (27a, 27b) aufnimmt, die entlang der Länge des Fassungsschlitzes in Richtung auf dessen Zentrum so vorbelastet sind, daß nur ein Teil jeden Armes an seinem freien Ende sich dem Zentrum des Schlitzes nähern kann, wobei die Modulanschlußeinrichtung eine Montagekarte (1) umfaßt, die die Seitensteckverbindungen in Gestalt leitender Streifen (4—14) trägt, die sich in einer parallelen Gruppierung ausgehend von dem in die Fassung einzusteckenden Kartenrand nach innen erstrecken, und wobei die relative Ausrichtung der Arme und der Streifen so ist, daß ein eins-zu-eins Kontakt vom Arm zum inneren Streifen erstellt wird, wenn die karte und die Fassung voll im Eingriff stehen, ausgenommen im Fall des verlängerten Anschlußkontaktes (14) und dem ihm zugeordneten Paar der Arme (27, 28), wobei die Streifenverlängerung (29) einen im wesentlichen L-förmigen leitenden Bereich bildet und sich entlang dem Kartenrand bis zur nächsten benachbarten Streifenposition erstreckt, aber nur bis zu einer Tiefe, die wesentlich vor dem allgemeinen Kontaktniveau (30) der voll mit dem Sockel in Eingriff stehenden Karte endet.

## Revendications

1. Système de traitement de données comprenant un processeur et au moins une cartouche de programme fixée de façon séparable, le processeur comportant un circuit de mise à zéro (28, 27, 41, 42, 43, 44, 45) et des moyens physiques et électriques pour la fixation séparable au processeur d'une ou plusieurs cartouches de programme, la ou chaque cartouche comportant des moyens de fixation coopérants (1, 4—14), lesdits moyens de fixation étant sous la forme de contacts prévus sur le processeur et de connecteurs de bord prévus sur les cartouches pouvant être fixées, caractérisé en ce qu'un connecteur de bord (14) sur la ou chaque cartouche a une configuration telle qu'il court-circuite une paire de contacts (27, 28) sur le processeur seulement à une position intermédiaire d'engagement des moyens de fixation, pour compléter un circuit de mise à zéro de processeur (27, 28, 41, 42, 43, 44, 45) temporairement pendant l'insertion et l'enlèvement de la cartouche respective par rapport au processeur et pour permettre les opérations du processeur avant et après l'insertion ou l'enlèvement d'une cartouche.

2. Système de traitement de données suivant la revendication 1, dans lequel les connecteurs de bord et les contacts constituent des ensembles préréglés respectifs qui sont alignés à raison de un pour un lorsque la cartouche est engagée, le connecteur de bord de configuration particulière (14) comportant une extension (29) qui pénètre dans une région qui serait normalement occupée par le connecteur de bord adjacent.

3. Système de traitement de données suivant la revendication 2, dans lequel ledit connecteur de bord adjacent possible est supprimé.

4. Système de traitement de données suivant l'une quelconque des revendications précédentes, dans lequel l'un des deux contacts temporairement court-circuités reste en contact avec le connecteur comportant l'extension, dans la position d'engagement complet des moyens de fixation, l'autre contact établissant et coupant le contact avec l'extension pendant le mouvement relatif du processeur et de la cartouche.

5. Système de traitement de données suivant la revendication 4, dans lequel, au moins en fonctionnement, le contact de processeur qui reste en contact est maintenu à une tension constante, le contact qui établit seulement le contact temporaire étant normalement maintenu à une tension différente par le circuit de mise à zéro du processeur sauf lorsque les deux contacts de processeur sont court-circuités, le changement du contact temporaire à la tension constante de l'autre contact de la paire déclenchant une opération de mise à zéro du processeur.

6. Système de traitement de données suivant l'une quelconque des revendications précédentes, dans lequel les moyens de fixation du côté du processeur comprennent un emboîtement d'enfichage (3) qui contient les contacts sous la forme de doigts élastiques (27a, 27b) espacés sur la longueur de la rainure de l'emboîtement ou partie femelle et déviés vers leur centre d'une manière telle que seule une partie de chaque doigt, situé vers leur extrémité libre, peut s'approcher du centre de la rainure, les moyens de fixation de la cartouche comprenant une carte de montage (1) portant les connecteurs de bord sous la forme de bandes conductrices (4—14) qui s'étendent parallèlement vers l'intérieur à partir du bord de la carte à insérer dans la partie femelle, les alignements relatifs des doigts et des bandes étant tels qu'on obtient un contact de chaque doigt avec chaque band respective à l'intérieur de la carte lorsque la carte et la partie femelle sont entièrement enclenchées, sauf dans le cas du connecteur comportant l'extension (14) et de la paire de doigts (27, 28) correspondant à ce connecteur, l'extension de la bande (29) étant placée le long du bord de la carte de manière à atteindre la position de la bande adjacente suivante, mais seulement à une profondeur bien inférieure au niveau (30) établissant le contact général de la carte et de la partie femelle complètement enclenchées, et formant une surface conductrice sensiblement en forme de L.

FIG. 1

FIG. 2

FIG. 3